(19) Europäisches Patentamt
European Patent Office
Office européen des brevets

(11) **EP 4 715 407 A1**

(12) **EUROPEAN PATENT APPLICATION**
published in accordance with Art. 153(4) EPC

(43) Date of publication:
**25.03.2026  Bulletin 2026/13**

(21) Application number: **24860377.1**

(22) Date of filing: **27.08.2024**

(51) International Patent Classification (IPC):
**G01R 31/374** (2019.01)     **G01R 31/396** (2019.01)
**G01R 31/382** (2019.01)     **G01R 31/385** (2019.01)
**G01R 31/392** (2019.01)     **G01R 19/165** (2006.01)
**G01R 19/10** (2006.01)      **B60L 58/10** (2019.01)

(52) Cooperative Patent Classification (CPC):
**B60L 58/10; G01R 19/10; G01R 19/165;
G01R 31/374; G01R 31/382; G01R 31/385;
G01R 31/392; G01R 31/396;** Y02E 60/10

(86) International application number:
**PCT/KR2024/012784**

(87) International publication number:
**WO 2025/048457 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.08.2023  KR 20230115861**

(71) Applicant: **LG Energy Solution, Ltd.
Seoul 07335 (KR)**

(72) Inventors:
• **CHOI, Soon-Hyung
  Daejeon 34122 (KR)**
• **YOON, Seo-Young
  Daejeon 34122 (KR)**
• **KIM, Young-Deok
  Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **APPARATUS AND METHOD FOR DIAGNOSING BATTERY**

(57)     The present disclosure relates to an apparatus and method for diagnosing a battery, which may diagnose a state of a battery in consideration of an overpotential. The apparatus and method for diagnosing a battery according to the present disclosure have an advantage in that charging and discharging at a criterion C-rate is not forced to diagnose the state of the battery because the state of the battery is diagnosed based on a corrected profile in which overpotential is removed from the battery profile.

FIG. 1

**Description**

TECHNICAL FIELD

The present application claims priority to Korean Patent Application No. 10-2023-0115861 filed on August 31, 2023, in the Republic of Korea, the disclosures of which are incorporated herein by reference.

The present disclosure relates to an apparatus and method for diagnosing a battery, and more particularly, to an apparatus and method for diagnosing a battery, which may diagnose a state of a battery in consideration of an overpotential.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

Conventionally, the state of the battery is diagnosed by analyzing the battery profile, which represents the correspondence relationship between capacity and voltage of the battery. For example, during the battery charging process, capacity and voltage of the corresponding battery are measured, and the battery state is diagnosed through analysis of the battery profile, which represents the correspondence relationship between the measured capacity and voltage. As another example, the state of the battery may be diagnosed based on the capacity and voltage measured during the battery discharge process.

Here, in order to diagnose the current state of the battery more accurately, a battery profile that accurately reflects the current state of the battery is required. However, there is a problem in that a low-rate charge and discharge such as 0.05 C (C-rate) is required to obtain such a battery profile. That is, since a low-rate charge and discharge is required in the past to diagnose the state of the battery, there are limitations in diagnosing the state of the battery.

For example, when charging and discharging a battery at 0.3 C or higher, since the acquired battery profile includes overpotential, the battery profile may not accurately reflect the current state of the battery due to the influence of overpotential. Since there is concern that the state of the battery may not be accurately diagnosed when using a battery profile including overpotential, low-rate charging and discharging is required to accurately diagnose the battery state.

DISCLOSURE

Technical Problem

The present disclosure is designed to solve the problems of the related art, and therefore the present disclosure is directed to providing an apparatus and method for diagnosing a battery, which may diagnose a battery in consideration of an overpotential.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

An apparatus for diagnosing a battery according to one aspect of the present disclosure may comprise a profile obtaining unit configured to obtain each of a plurality of battery profiles representing a correspondence relationship between voltage and capacity of each of a plurality of batteries; a profile correcting unit configured to generate a plurality of corrected profiles by correcting the plurality of battery profiles based on a preset overpotential profile, and generate an adjusted positive electrode profile and an adjusted negative electrode profile corresponding to each battery by adjusting a preset criterion positive electrode profile and a criterion negative electrode profile to correspond to each of the plurality of corrected profiles; and a control unit configured to extract a diagnosis factor regarding a positive electrode change rate for each battery from the criterion positive electrode profile and the adjusted positive electrode profile, and diagnose a state of the plurality of batteries based on the extracted plurality of diagnosis factors.

The overpotential profile may be a profile that represents a voltage difference for each capacity between a battery profile of a criterion battery for a criterion C-rate and a battery profile of the criterion battery for a target C-rate set for the plurality of batteries.

The profile correcting unit may be configured to generate the plurality of corrected profiles by calculating a voltage difference for each capacity between each of the plurality of battery profiles and the overpotential profile.

The overpotential profile may be configured to be stored in advance for each of a plurality of C-rates.

The profile correcting unit may be configured to select an overpotential profile corresponding to the target C-rate among a plurality of overpotential profiles stored in advance, and generate the plurality of corrected profiles using the selected overpotential profile.

The control unit may be configured to select a diagnosis factor out of a threshold range among the plurality of diagnosis factors by considering a distribution of the plurality of diagnosis factors, and diagnose the state of a battery corresponding to the selected diagnosis factor as an abnormal state.

The profile correcting unit may be configured to generate a comparison full-cell profile based on the criterion positive electrode profile and the criterion negative electrode profile, and generate the adjusted positive electrode profile and the adjusted negative electrode profile by adjusting the criterion positive electrode profile and the criterion negative electrode profile until the generated comparison full-cell profile corresponds to the corrected profile.

A battery pack according to another aspect of the present disclosure may comprise the apparatus for diagnosing a battery according to one aspect of the present disclosure.

A battery manufacturing system according to still another aspect of the present disclosure may comprise the apparatus for diagnosing a battery according to one aspect of the present disclosure.

A vehicle according to still another aspect of the present disclosure may comprise the apparatus for diagnosing a battery according to one aspect of the present disclosure.

A method for diagnosing a battery according to still another aspect of the present disclosure may comprise: a profile obtaining step of obtaining each of a plurality of battery profiles representing a correspondence relationship between voltage and capacity of each of a plurality of batteries; a corrected profile generating step of generating a plurality of corrected profiles by correcting the plurality of battery profiles based on a preset overpotential profile; a profile adjusting step of generating an adjusted positive electrode profile and an adjusted negative electrode profile corresponding to each battery by adjusting a preset criterion positive electrode profile and a criterion negative electrode profile to correspond to each of the plurality of corrected profiles; a diagnosis factor extracting step of extracting a diagnosis factor regarding a positive electrode change rate for each battery from the criterion positive electrode profile and the adjusted positive electrode profile; and a state diagnosing step of diagnosing a state of the plurality of batteries based on the extracted plurality of diagnosis factors.

Advantageous Effects

The apparatus for diagnosing a battery according to the present disclosure has an advantage in that charging and discharging at the criterion C-rate is not forced to diagnose the state of the battery because the state of the battery is diagnosed based on a corrected profile in which overpotential is removed from the battery profile. In other words, since the state of the battery may be diagnosed even if the battery is charged and discharged at a C-rate other than the criterion C-rate, the state of the battery may be quickly diagnosed without restrictions on the charge and discharge conditions.

In addition, the apparatus for diagnosing a battery has the advantage of being able to quickly distinguish and diagnose a normal battery and an abnormal battery by relatively comparing the states of a plurality of batteries based on the distribution of a plurality of diagnosis factors.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing an apparatus for diagnosing a battery according to an embodiment of the present disclosure.

FIG. 2 is a diagram schematically showing an overpotential profile according to an embodiment of the present disclosure.

FIG. 3 is a diagram schematically showing a battery profile according to an embodiment of the present disclosure.

FIG. 4 is a diagram schematically showing a corrected profile according to an embodiment of the present disclosure.

FIG. 5 is a diagram schematically showing the distribution of diagnosis factors according to an embodiment of the present disclosure.

FIG. 6 is a diagram showing the distribution of diagnosis factors according to an embodiment of the present disclosure.

FIGS. 7 to 14 are diagrams for explaining the process of adjusting a criterion positive electrode profile and a criterion negative electrode profile according to an embodiment of the present disclosure.

FIG. 15 is a diagram showing an exemplary configuration of a battery pack according to another embodiment of the present disclosure.

FIG. 16 is a drawing for explaining a process of manufacturing a battery cell by a battery manufacturing system according to still another embodiment of the present disclosure.

FIG. 17 is a diagram showing an exemplary configuration of a vehicle according to still another embodiment of the present disclosure.

FIG. 18 is a diagram schematically showing a method for diagnosing a battery according to still another embodiment of the present disclosure.

BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

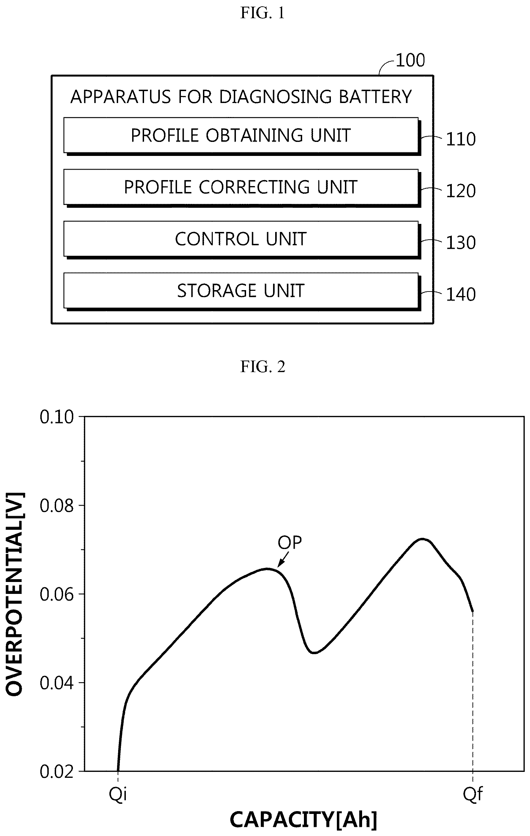

FIG. 1 is a diagram schematically illustrating an apparatus 100 for diagnosing a battery according to an embodiment of the present disclosure.

Referring to FIG. 1, the apparatus 100 for diagnosing a battery may include a profile obtaining unit 110, a profile correcting unit 120, and a control unit 130.

The profile obtaining unit 110 may be configured to obtain each of a plurality of battery profiles BP indicating the correspondence relationship between the voltage and capacity of each of a plurality of batteries.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

Specifically, the battery profile BP is a profile that represents the correspondence relationship between voltage (V) and capacity (Q) when the SOC (State of Charge) of a battery is charged from 0% to 100%. Conversely, the battery profile BP may represent the correspondence relationship between voltage (V) and capacity (Q) until the SOC of the battery is discharged from 100% to 0%. For example, the battery profile BP may be generated based on the voltage and electric capacity while the battery is being charged or discharged at a certain C-rate. Here, the C-rate must be kept constant while the battery profile BP is generated. That is, when the C-rate for charging and discharging is set, the set C-rate remains constant until charging and discharging ends.

For example, the profile obtaining unit 110 may directly receive the battery profile BP from the outside. That is, the profile obtaining unit 110 may obtain the battery profile BP by being connected to the outside by wire and/or wirelessly and receiving the battery profile BP.

As another example, the profile obtaining unit 110 may receive battery information about the voltage (V) and capacity (Q) of the battery. Additionally, the profile obtaining unit 110 may generate a battery profile BP based on the received battery information. That is, the profile obtaining unit 110 may obtain the battery profile BP by directly generating the battery profile BP based on battery information.

The profile obtaining unit 110 may be connected to enable communication with the profile correcting unit 120. For example, the profile obtaining unit 110 may be connected to the profile correcting unit 120 by wire and/or wirelessly. The profile obtaining unit may transmit the obtained battery profile BP to the profile correcting unit 120.

The profile correcting unit 120 may be configured to generate a plurality of corrected profiles CP by correcting the plurality of battery profiles BP based on the preset overpotential profile OP.

Here, the overpotential profile OP is a profile representing a correspondence relationship between capacity and overpotential. For example, the overpotential profile OP is a profile representing overpotential according to capacity. Specifically, the overpotential profile OP may be a profile representing a voltage difference for each capacity between a battery profile of a criterion battery for a criterion C-rate and a battery profile of a criterion battery for a target C-rate set for a plurality of batteries.

For example, it is assumed that the criterion C-rate is 0.05 C and the target C-rate is 0.3 C. When the criterion battery is charged (or discharged) at 0.05 C, a first battery profile may be obtained. When the criterion battery is charged (or discharged) at 0.3 C, a second battery profile may be obtained. The difference in voltage between the first battery profile and the second battery profile for the same capacity may be calculated as the overpotential. That is, the overpotential for each capacity between the first battery profile and the second battery profile is calculated, and an overpotential profile OP representing the correspondence relationship between the capacity and the overpotential may be generated. In general, if a battery is charged and discharged at a C-rate higher than the criterion C-rate, the measured battery voltage may include overpotential. Therefore, by removing the battery profile based on the criterion C-rate from the battery profile based on the target C-rate (the voltage difference for each capacity is calculated), the overpotential profile OP may be generated.

FIG. 2 is a diagram schematically showing an overpotential profile OP according to an embodiment of the present disclosure.

Specifically, FIG. 2 is a diagram showing the overpotential profile OP generated in the process of discharging the criterion battery from start capacity (Qi) to end capacity (Qf). The first battery profile may be generated as the criterion battery is discharged at the criterion C-rate from start capacity (Qi) to end capacity (Qf). In addition, the second battery profile may be generated as the criterion battery is discharged at the target C-rate from start capacity (Qi) to end capacity (Qf). The overpotential profile OP may be generated by calculating the voltage difference for each discharge capacity between the first battery profile and the second battery profile from start capacity (Qi) to end capacity (Qf).

The profile correcting unit 120 may be configured to generate a plurality of corrected profiles CP by calculating the voltage difference for each capacity between each of the plurality of battery profiles BP and the overpotential profile OP.

Specifically, the profile correcting unit 120 may remove the overpotential profile OP from the battery profile BP. For example, the profile correcting unit 120 may calculate the difference between the voltage of the battery profile BP and the overpotential of the overpotential profile OP for the same capacity. The profile correcting unit 120 may generate a corrected profile CP by calculating the difference between the voltage of the battery profile BP and the overpotential of the overpotential profile OP for the entire capacity. In other words, the corrected profile CP is a profile in which the overpotential profile OP is removed from the battery profile BP.

For example, it is assumed that the overpotential profile OP is a profile based on the voltage difference between the first battery profile of the criterion battery for 0.05 C and the second battery profile of the criterion battery for 0.3 C. The corrected profile CP generated by the difference between the battery profile BP for 0.3 C and the overpotential profile OP may be a profile corresponding to 0.05 C. That is, since the overpotential of the overpotential profile OP is removed from the battery profile BP for 0.3 C, the corrected profile CP for 0.05 C may be derived.

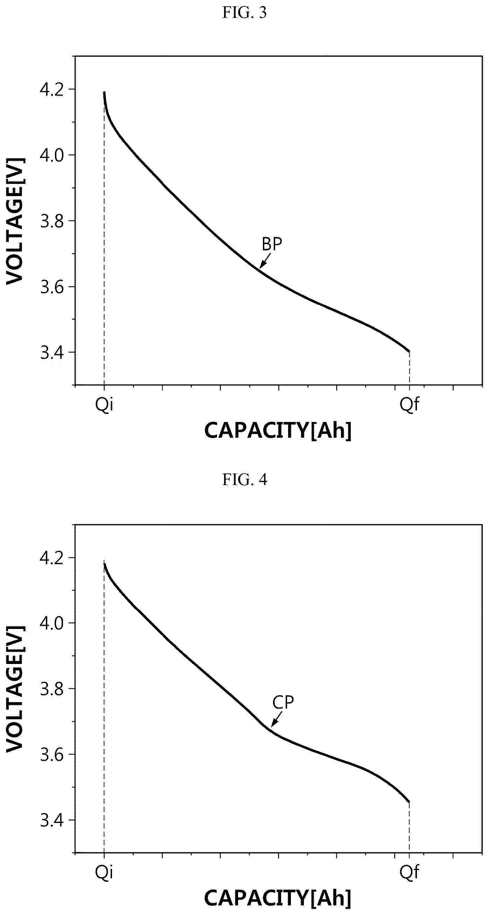

FIG. 3 is a diagram schematically showing a battery profile BP according to an embodiment of the present disclosure. FIG. 4 is a diagram schematically showing a corrected profile CP according to an embodiment of the present disclosure.

Specifically, the battery profile BP in FIG. 3 is a profile obtained when the battery is discharged at the target C-rate from start capacity (Qi) to end capacity (Qf).

Referring to FIGS. 2 to 4, the profile correcting unit 120 may generate the corrected profile CP of FIG. 4 by removing the overpotential profile OP of FIG. 2 from the battery profile BP of FIG. 3. Here, the target C-rate corresponding to the battery profile BP in FIG. 3 and the target C-rate corresponding to the overpotential profile OP in FIG. 2 are the same. In other words, the corrected profile CP may be generated based on the battery profile BP and the overpotential profile OP for the same target C-rate.

The profile correcting unit 120 may be configured to generate an adjusted positive electrode profile and an adjusted negative electrode profile corresponding to each battery by adjusting a preset criterion positive electrode profile and a preset criterion negative electrode profile to correspond to each of the plurality of corrected profiles CP.

The criterion positive electrode profile may be a profile representing a correspondence relationship between the capacity and voltage of the preset criterion positive electrode cell to correspond to the positive electrode of the battery. For example, the criterion positive electrode cell may be a positive electrode coin half-cell or a positive electrode of a three-electrode cell. Additionally, the criterion negative electrode profile may be a profile representing a correspondence relationship between the capacity and voltage of the preset criterion negative electrode cell to correspond to the negative electrode of the battery. For example, the criterion negative electrode cell may be a negative electrode coin half-cell or a negative electrode of a three-electrode cell.

Specifically, the profile correcting unit 120 may adjust the criterion positive electrode profile and the criterion negative electrode profile to correspond to the corrected profile CP. More specifically, the profile correcting unit 120 may adjust the criterion positive electrode profile and the criterion negative electrode profile to generate an adjusted positive electrode profile and an adjusted negative electrode profile. In addition, the profile correcting unit 120 may generate a comparison full-cell profile from the adjusted positive electrode profile and the adjusted negative electrode profile. The profile correcting unit 120 may adjust the criterion positive electrode profile and the criterion negative electrode profile until the comparison full-cell profile corresponds to the corrected profile CP.

For example, the profile correcting unit 120 may generate a plurality of comparison full-cell profile by shifting the criterion positive electrode profile and the criterion negative electrode profile or scaling the capacities thereof, and specify a comparison full-cell profile with the minimum error with the corrected profile CP among the plurality of comparison full-cell profiles. Additionally, an adjusted positive electrode profile and an adjusted negative electrode profile corresponding to the specified comparison full-cell profile may be determined.

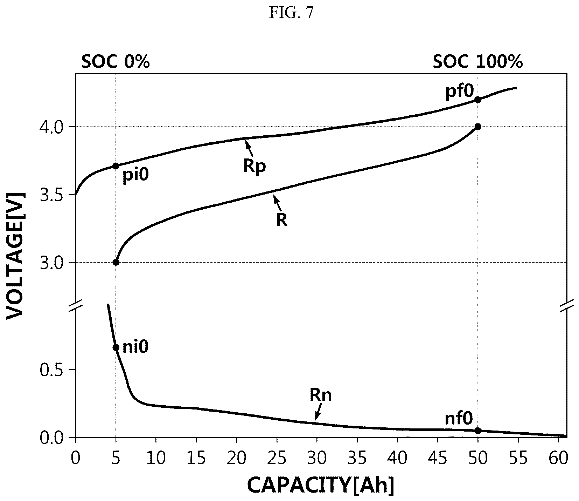

Related to this, a more specific embodiment in which the positive electrode profile of the battery by adjusting the criterion positive electrode profile and the criterion negative electrode profile to correspond to the corrected profile CP will be described later with reference to FIGS. 7 to 14.

The control unit 130 may be configured to extract a diagnosis factor regarding the positive electrode change rate for each battery from the criterion positive electrode profile and the adjusted positive electrode profile.

Specifically, the control unit 130 may determine the positive electrode change rate (ps) by calculating the change rate of the adjusted positive electrode profile to the criterion positive electrode profile.

For example, the control unit 130 may extract a diagnosis factor for each of the plurality of batteries based on the adjusted positive electrode profile corresponding to each of the plurality of batteries. Here, it is noted that the diagnosis factor extracted for the plurality of batteries is the same item. That is, the control unit 130 may extract a plurality of diagnosis factor to correspond to the plurality of batteries.

The control unit 130 may be configured to diagnose the state of the plurality of batteries based on the extracted plurality of diagnosis factors.

Specifically, since the plurality of diagnosis factors are values for the same item, the control unit 130 may distinguish and diagnose a normal battery and an abnormal battery by considering the distribution of the plurality of diagnosis factors.

Preferably, the control unit 130 may compare the plurality of diagnosis factors with a threshold range (TH) using a statistical analysis method, and diagnose the state of the battery as a normal state or an abnormal state based on the comparison result.

For example, the control unit 130 may be configured to select a diagnosis factor out of the threshold range (TH) among a plurality of diagnosis factors by considering a distribution of the plurality of diagnosis factors, and to diagnose the state of the battery corresponding to the selected diagnosis factor as an abnormal state. Conversely, the control unit 130 may be configured to select a diagnosis factor included in the threshold range (TH) among a plurality of diagnosis factors, and to diagnose the state of the battery corresponding to the selected diagnosis factor as a normal state.

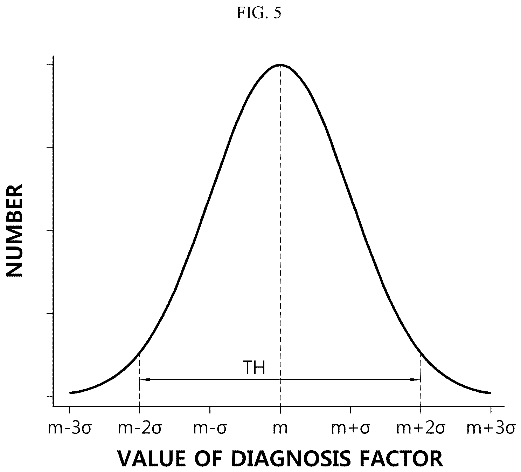

FIG. 5 is a diagram schematically showing the distribution of diagnosis factors according to an embodiment of the present disclosure. Specifically, FIG. 5 is a diagram illustrating an embodiment in which the distribution of a plurality of diagnosis factors follows a normal distribution. For example, if the average value of the diagnosis factors is m and the standard deviation is $\sigma$, the threshold range TH may be set as a range of m-2$\sigma$ or more and m+2$\sigma$ or less. The control unit 130 may classify the plurality of diagnosis factors into diagnosis factors that belong to the threshold range TH and diagnosis factors that do not belong to the threshold range TH. Additionally, the control unit 130 may diagnose the state of the battery corresponding to the diagnosis factor belonging to the threshold range TH as a normal state, and diagnose the state of the battery corresponding to the diagnosis factor not belonging to the threshold range TH as an abnormal state.

In the above, for convenience of explanation, an embodiment of the threshold range TH set based on 2$\sigma$ has been described, but it should be noted that the threshold range TH is not limited to the range of m-2$\sigma$ to m+2$\sigma$.

The apparatus 100 for diagnosing a battery according to the present disclosure diagnoses the state of the battery based on the corrected profile CP in which the overpotential is removed from the battery profile BP, so there is an advantage in that charging and discharging with the criterion C-rate is not forced to diagnose the state of the battery. In other words, since the state of the corresponding battery may be diagnosed even if the battery is charged and discharged with a C-rate other than the criterion C-rate, the state of the battery may be diagnosed quickly without restrictions on charging and discharging conditions.

In addition, the apparatus 100 for diagnosing a battery has an advantage of quickly distinguishing and diagnosing a normal battery and an abnormal battery by relatively comparing the states of the plurality of batteries based on the distribution of the plurality of diagnosis factors.

Meanwhile, the control unit 130 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the apparatus 100 for diagnosing a battery may further include a storage unit 140. The storage unit 140 may store data necessary for operation and function of each component of the apparatus 100 for diagnosing a battery, data generated in the process of performing the operation or function, or the like. The storage unit 140 is not particularly limited in its kind as long as it is a known information storage means that can record, erase, update and read data. As an example, the information storage means may include RAM, flash memory, ROM, EEPROM, registers, and the like. In addition, the storage unit 140 may store program codes in which processes executable by the control unit 130 are defined.

For example, the storage unit 140 may store the plurality of battery profiles BP, the overpotential profile OP, the plurality of corrected profiles CP, the criterion positive electrode profile, the criterion negative electrode profile, the adjusted positive electrode profile, the adjusted negative electrode profile, and the plurality of diagnosis factors.

Below, a comparison is made between a conventional battery state diagnosis method and a battery state diagnosis method by the apparatus 100 for diagnosing a battery.

For example, if a low-rate charge/discharge of 0.05 C is forced to obtain the battery profile BP as in the conventional method, it may take about 20 hours just to obtain the battery profile BP. In addition, additional time may be required in the process of diagnosing the state of the battery according to the obtained battery profile BP. That is, since a considerable amount of time is required in the process of obtaining the battery profile BP according to the conventional method, there is a problem in that the state of the battery cannot be diagnosed quickly.

On the other hand, if the battery is charged and discharged at 0.3C as in the embodiment of the present disclosure, the battery profile BP may be acquired in about 3 hours. That is, according to an embodiment of the present disclosure, the time required to acquire the battery profile BP may be dramatically reduced compared to the conventional method. However, since the battery profile BP acquired in this way includes overpotential, the apparatus 100 for diagnosing a battery may generate a corrected profile CP by removing the overpotential from the battery profile BP, and diagnose the state of the battery according to the generated corrected profile CP. Therefore, even if the additional time required in the process of generating the corrected profile CP and the process of diagnosing the state of the battery is put into consideration, the apparatus 100 for diagnosing a battery has an advantage of being able to diagnose the state of the battery very quickly compared to the conventional method.

The overpotential profile OP may be configured to be stored in advance for each of a plurality of C-rates.

Specifically, a plurality of overpotential profile OPs may be provided, and the C-rates respectively corresponding to the plurality of overpotential profiles OP may be different. For example, based on a unit C-rate, an overpotential profile OP corresponding to each C-rate may be stored in advance.

Additionally, an overpotential profile OP for C-rate that is not experimentally obtained may be obtained and stored through interpolation or extrapolation between similar overpotential profiles OP. Specifically, the profile correcting unit 120 may generate an overpotential profile OP for various C-rates in addition to the overpotential profile OP stored in advance through interpolation or extrapolation, and store the generated overpotential profile OP in the storage unit 140. For example, if the overpotential profile OP corresponding to 1 C and the overpotential profile OP corresponding to 1.2 C are stored in advance, an overpotential profile OP corresponding to 1.1 C may be additionally obtained based on the difference between the two overpotential profiles OP.

The profile correcting unit 120 may be configured to select an overpotential profile OP corresponding to the target C-rate among the plurality of overpotential profiles OP stored in advance.

Here, the target C-rate is a C-rate set for the battery. For example, if a plurality of battery profiles BP is obtained in the process of charging the plurality of batteries at 0.3 C, the target C-rate is 0.3 C. The profile correcting unit 120 may select the overpotential profile OP corresponding to 0.3 C among the plurality of overpotential profiles OP.

The profile correcting unit 120 may be configured to generate a plurality of corrected profiles CP using the selected overpotential profile OP.

For example, the profile correcting unit 120 may generate a plurality of corrected profiles CP by calculating the difference between each of the plurality of battery profiles BP and the selected overpotential profile OP. That is, the profile correcting unit 120 may obtain a plurality of corrected profiles CP from which overpotential is commonly removed.

Because overpotential corresponds to noise, the battery profile BP having overpotential may not accurately reflect the current state of the battery. Therefore, the apparatus 100 for diagnosing a battery according to an embodiment of the present disclosure may remove the overpotential included in the battery profile BP using the overpotential profile OP corresponding to the target C-rate. In other words, the apparatus 100 for diagnosing a battery has an advantage of more accurately diagnosing the state of the battery based on the corrected profile CP from which overpotential is removed.

For example, it is assumed that a battery and the apparatus 100 for diagnosing a battery are equipped in a final application. Here, the final application means a final product to which the apparatus 100 for diagnosing a battery may be applied, and may include a motorcycle, a vehicle, or an ESS (Energy storage system). That is, the apparatus 100 for diagnosing a battery may be an on-board diagnostic device equipped in the final application. In this case, the C-rate for the battery may not be included in the plurality of C-rates corresponding to the pre-stored overpotential profile OP.

That is, in a situation where the battery is actually operated in the final application, the C-rate for the battery may change due to various environmental factors. Therefore, the C-rate for the battery may not be included in the plurality of C-rates corresponding to the pre-stored overpotential profile OP. In this case, if the overpotential included in the battery profile BP is removed based on the battery profile BP and the overpotential profile OP having different C-rates, the generated corrected profile CP may not accurately reflect the state of the battery.

Therefore, if the C-rate of the battery is not included in the plurality of C-rates, the profile correcting unit 120 may generate an overpotential profile OP corresponding to the C-rate of the battery by determining two C-rates adjacent to the C-rate of the battery among the plurality of C-rates and interpolating the overpotential profiles corresponding to the determined C-rates. Then, the profile correcting unit 120 may generate a corrected profile CP by removing the overpotential included in the battery profile BP based on the battery profile BP and the generated overpotential profile OP.

Meanwhile, a plurality of overpotential profiles (charge overpotential profiles) corresponding to the charge C-rate and a plurality of overpotential profiles (discharge overpotential profiles) corresponding to the discharge C-rate may be stored in advance. That is, the plurality of charge overpotential profiles and the plurality of discharge overpotential profiles may be stored independently.

In general, batteries exhibit a hysteresis effect during charging and discharging, so even if the voltage is the same, the charging capacity and discharging capacity may have different values. Therefore, in order to more accurately diagnose the state of the battery, it is desirable to store the plurality of overpotential profiles OP to be distinguished depending on the charge C-rate and the discharge C-rate.

The control unit 130 may determine the charging and discharging process (charging process or discharging process) corresponding to the battery profile BP. For example, the control unit 130 may determine the charging and discharging process of the battery profile BP by comparing the sizes of start capacity and end capacity. Additionally, the control unit 130 may select the corresponding overpotential profile OP based on the determined charging and discharging process and the target C-rate.

The apparatus 100 for diagnosing a battery according to an embodiment of the present disclosure may more accurately diagnose the state of a plurality of batteries by selecting an overpotential profile OP in consideration of the target C-rate and the charging and discharging process.

Below, examples of the positive electrode factor, the negative electrode factor, and the positive and negative electrode factors are described.

The positive electrode factor may include at least one of a positive electrode start potential, a positive electrode end potential, a positive electrode change rate, and a positive electrode loading amount of the battery based on the adjusted positive electrode profile.

The positive electrode start potential is a start potential of the adjusted positive electrode profile, and the positive electrode end potential is an end potential of the adjusted positive electrode profile. Specifically, the positive electrode start potential is a potential value of the positive electrode participation initiating point pi of the adjusted positive electrode profile. The positive electrode end potential is a potential value of the positive electrode participation finalizing point pf of the adjusted positive electrode profile.

The positive electrode change rate (ps) may mean a change rate [%] of the adjusted positive electrode profile with respect to the criterion positive electrode profile. Specifically, the positive electrode change rate (ps) may be a contraction rate or expansion rate of the adjusted positive electrode profile with respect to the criterion positive electrode profile. For example, if the adjusted positive electrode profile is 10% shrinkage from the criterion positive electrode profile, the positive electrode change rate (ps) is 90%. Conversely, if the adjusted positive electrode profile is 10% extension of the criterion positive electrode profile, the positive electrode change rate (ps) is 110%.

The positive electrode loading amount (p_loading) refers to an amount of positive electrode active material coated on the positive electrode current collector. Since the adjusted positive electrode profile is a profile representing the current state of the positive electrode of the battery, the control unit 130 may calculate the positive electrode loading amount (p_loading) based on the adjusted positive electrode profile. For example, the control unit 130 may calculate the positive electrode loading amount (p_loading) in consideration of the positive electrode change rate (ps), a preset criterion positive electrode capacity, and a preset criterion area. Here, the criterion positive electrode capacity may mean a capacity of a preset criterion positive electrode cell. Also, the criterion area may mean the area of the preset criterion positive electrode cell. Specifically, the control unit 130 may calculate the positive electrode loading amount (p_loading) using Equation 1 below.

[Equation 1]

$$\text{p\_loading} = \text{ps} \times Q_{rc} \div A_{pc}$$

Here, p_loading represents the positive electrode loading amount, and ps represents the positive electrode change rate. $Q_{rc}$ represents the criterion positive electrode capacity, and $A_{pc}$ represents the criterion area.

The negative electrode diagnosis factor may include at least one of a negative electrode start potential, a negative electrode end potential, a negative electrode change rate, and a negative electrode loading amount of the battery based on the adjusted negative electrode profile.

The negative electrode start potential is a start potential of the adjusted negative electrode profile, and the negative electrode end potential is an end potential of the adjusted negative electrode profile. Specifically, the negative electrode start potential is a potential value of the negative electrode participation initiating point ni of the adjusted negative electrode profile. The negative electrode end potential is a potential value of the negative electrode participation finalizing point nf of the adjusted negative electrode profile.

The negative electrode change rate (ns) may mean the change rate [%] of the adjusted negative electrode profile with respect to the criterion negative electrode profile. Specifically, the negative electrode change rate (ns) may be the contraction rate or expansion rate of the adjusted negative electrode profile with respect to the criterion negative electrode profile. For example, if the adjusted negative electrode profile is 10% shrinkage from the criterion negative electrode profile, the negative electrode change rate (ns) is 90%. Conversely, if the adjusted negative electrode profile is 10% extension of the criterion negative electrode profile, the negative electrode change rate (ns) is 110%.

The negative electrode loading amount (n_loading) refers to the amount of negative electrode active material coated on the negative electrode current collector. Since the adjusted negative electrode profile is a profile indicating the current state of the negative electrode of the battery, the control unit 130 may calculate the negative electrode loading amount (n_loading) based on the adjusted negative electrode profile. Specifically, the control unit 130 may calculate the negative electrode loading amount (n_loading) in consideration of the negative electrode change rate (ns), a preset criterion negative electrode capacity, and a preset criterion area. Here, the criterion negative electrode capacity may mean the capacity of a preset criterion negative electrode cell. The criterion area may mean the area of a preset criterion negative electrode cell. Specifically, the control unit 130 may calculate the negative electrode loading amount (n_loading) based on the negative electrode change rate (ns), the criterion negative electrode capacity, and the criterion area using Equation 2 below.

[Equation 2]

$$n\_loading = ns \times Q_{ra} \div A_{pa}$$

Here, n_loading represents the negative electrode loading amount, and ns represents the negative electrode change rate. $Q_{ra}$ represents the criterion negative electrode capacity, and $A_{pa}$ represents the criterion area.

The positive and negative electrode factors may include an NP ratio based on the positive electrode loading amount and the negative electrode loading amount.

Specifically, the NP ratio refers to the rate of positive electrode loading amount to negative electrode loading amount. For example, the control unit 130 may calculate the NP ratio using Equation 3 below.

[Equation 3]

$$np\ ratio = \frac{n\_loading}{p\_loading}$$

Here, np ratio is the NP ratio, p-loading is the positive electrode loading amount according to Equation 1, and n-loading is the negative electrode loading amount according to Equation 2.

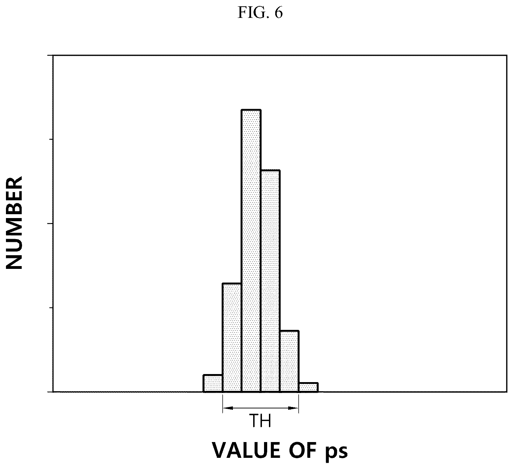

FIG. 6 is a diagram showing the distribution of diagnosis factors according to an embodiment of the present disclosure.

Specifically, FIG. 6 is a profile showing the distribution of a plurality of positive electrode change rates. As in the previous embodiment, FIG. 6 assumes that a range of 2 standard deviations for the mean value is set as the threshold range (TH).

The control unit 130 may extract a diagnosis factor for one diagnosis item regarding a plurality of batteries and diagnose the state of the plurality of batteries based on the distribution of the extracted plurality of diagnosis factors.

For example, in the embodiment of FIG. 6, the item of interest may be selected as the positive electrode change rate. The control unit 130 may extract a positive electrode change rate from the plurality of adjusted positive electrode profiles for the plurality of batteries. Then, the control unit 130 may select a positive electrode change rate that is out of the threshold range (TH) among the plurality of positive electrode change rates. That is, the control unit 130 may select a positive electrode change rate that exceeds an upper limit (m+2σ) of the threshold range (TH) or is less than a lower limit (m-2σ) of the threshold range (TH). Then, the control unit 130 may diagnose the state of the battery corresponding to the selected positive electrode change rate as an abnormal state. Conversely, the control unit 130 may diagnose the state of the remaining batteries as a normal state.

The apparatus 100 for diagnosing a battery according to an embodiment of the present disclosure may extract a diagnosis factor for the item of interest and diagnose the state of a plurality of batteries based on the extracted diagnosis factor. Therefore, the apparatus 100 for diagnosing a battery has an advantage of being able to quickly diagnose the state of the battery according to a corrected profile CP with overpotential removed and to diagnose the state of the battery more specifically for each subdivided item.

Below, an embodiment in which the profile correcting unit 120 adjusts the criterion positive electrode profile and the criterion negative electrode profile will be described in detail.

The profile correcting unit 120 may be configured to generate a comparison full-cell profile based on the criterion positive electrode profile and the criterion negative electrode profile.

Specifically, the comparison full-cell profile may be generated according to the voltage difference for each capacity for the criterion positive electrode profile and the criterion negative electrode profile. For example, it is assumed that the voltage of the criterion positive electrode profile corresponding to a certain capacity x is Vp, and the voltage of the criterion negative electrode profile is Vn. The voltage of the comparison full-cell profile corresponding to the capacity X may be calculated as "Vp - Vn". The profile correcting unit 120 may generate a comparison full-cell profile by calculating the voltage difference between the criterion positive electrode profile and the criterion negative electrode profile for the entire capacity.

The profile correcting unit 120 may be configured to generate an adjusted positive electrode profile and an adjusted negative electrode profile by adjusting the criterion positive electrode profile and the criterion negative electrode profile until the generated comparison full-cell profile corresponds to the corrected profile CP.

Specifically, the profile correcting unit 120 may calculate an error between the comparison full-cell profile and the corrected profile CP. Additionally, the profile correcting unit 120 may adjust the criterion positive electrode profile and the criterion negative electrode profile until the error between the comparison full-cell profile and the corrected profile CP is minimized. If the comparison full-cell profile that minimizes the error with the corrected profile CP is determined, the adjusted positive electrode profile and the adjusted negative electrode profile, which are the basis of the determined comparison full-cell profile, may be estimated as the positive electrode profile and the negative electrode profile that represent the current state of the battery. With current technology, there is a problem that it is not possible to directly obtain the positive electrode profile and the negative electrode profile indicating the current state of the battery without directly disassembling the battery. Therefore, it may be strongly assumed that the adjusted positive electrode profile and the adjusted negative electrode profile, which are the basis of the comparison full-cell profile determined through the adjustment process, are used as the positive electrode profile and the negative electrode profile that reflect the current state of the battery.

Hereinafter, with reference to FIGS. 7 to 14, an embodiment in which the profile correcting unit 120 adjusts the criterion positive electrode profile and the criterion negative electrode profile will be described in more detail.

FIGS. 7 to 14 are diagrams for explaining a process of adjusting a criterion positive electrode profile and a criterion negative electrode profile according to an embodiment of the present disclosure. Below, for convenience of explanation, the corrected profile CP according to an embodiment of the present disclosure is described as a measurement full-cell profile M.

FIG. 7 is a graph referenced to for explaining an example of the criterion positive electrode profile Rp and the criterion negative electrode profile Rn, respectively. In the graph of FIG. 7, the horizontal axis (X-axis) represents capacity (Ah) and the vertical axis (Y-axis) represents voltage (V).

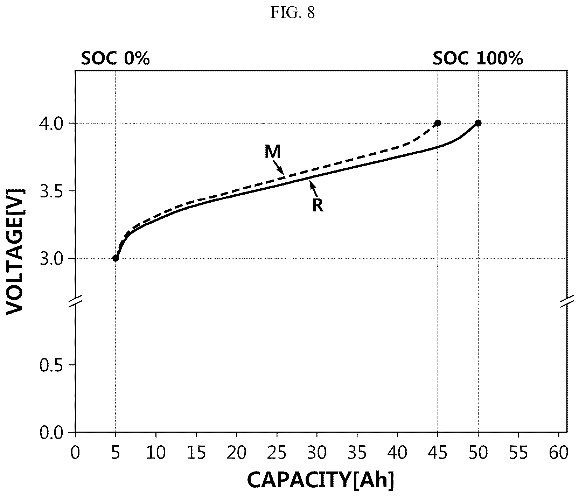

FIG. 8 is a graph referenced to for explaining an example of the measurement full-cell profile M of the target battery. In the graph of FIG. 8, the horizontal axis (X-axis) represents capacity (Ah) and the vertical axis (Y-axis) represents voltage (V).

The profile correcting unit 120 may be configured to compare the measurement full-cell profile M and at least one comparison full-cell profile. Here, the comparison full-cell profile may be the result of synthesizing (combining) the adjusted positive electrode profile and the adjusted negative electrode profile based on the criterion positive electrode profile Rp and the criterion negative electrode profile Rn, respectively, stored in the storage unit 140.

In other words, when the criterion full-cell profile R is the result of subtracting a part of the criterion negative electrode profile Rn from a part of the criterion positive electrode profile Rp, the comparison full-cell profile may be said to be the result of subtracting a part of the adjusted negative electrode profile from a part of the adjusted positive electrode profile.

The profile correcting unit 120 may generate at least one comparison full-cell profile by directly adjusting the criterion positive electrode profile Rp and the criterion negative electrode profile Rn. Alternatively, at least one comparison full-cell profile may be secured in advance based on the criterion positive electrode profile Rp and the criterion negative electrode profile Rn and stored in the storage unit 140. In this case, the profile correcting unit 120 may obtain the comparison full-cell profile by accessing the storage unit 140 and reading the comparison full-cell profile.

The profile correcting unit 120 may generate a plurality of comparison full-cell profiles from the criterion positive electrode profile Rp and the criterion negative electrode profile Rn by repeating the process of adjusting each of the criterion positive electrode profile Rp and the criterion negative electrode profile Rn to various levels and then synthesizing them. The comparison full-cell profile may also be called an 'adjusted criterion full-cell profile'.

The profile correcting unit 120 may specify any one comparison full-cell profile that has a minimum error with the measurement full-cell profile M among the plurality of comparison full-cell profiles.

Next, the profile correcting unit 120 may determine the adjusted positive electrode profile and the adjusted negative electrode profile mapped with the specified comparison full-cell profile as the positive electrode profile and the negative electrode profile of the battery. In the following, it should be noted that the positive electrode profile is a finally determined adjusted positive electrode profile, and the negative electrode profile is a finally determined adjusted positive electrode profile.

In relation to this, various methods known at the filing time of the present disclosure may be employed to determine the error between two profiles, each of which may be expressed in a two-dimensional coordinate system. For example, the integral value of the absolute value of the area between two profiles or RMSE (Root Mean Square Error) may be used as the error between two profiles.

According to this configuration of the present disclosure, various state information about the battery may be obtained based on the finally determined positive electrode profile and negative electrode profile. The finally determined positive electrode profile and negative electrode profile may be mapped with the comparison full-cell profile mapped with the minimum error. In particular, it may be said that the comparison full-cell profile by the finally determined positive electrode profile and negative electrode profile is almost identical to the measurement full-cell profile M in terms of shape.

Therefore, according to the present disclosure, the positive electrode profile and the negative electrode profile of the battery may be obtained even without disassembling the battery.

If the battery is a new battery, the present disclosure may be more usefully utilized to diagnose whether a defect has occurred in the battery and, if so, what type of defect it is by analyzing the positive electrode profile and the negative electrode profile of the battery.

If the battery is already being used after being verified as good, it is possible to determine the extent to which the battery has deteriorated for each deterioration item through the positive electrode profile and the negative electrode profile of the battery.

Furthermore, according to the present disclosure, the positive electrode profile and the negative electrode profile of the battery may be obtained through a simple manner. Even if only one criterion positive electrode profile Rp and one criterion negative electrode profile Rn are stored in the storage unit 140, the present disclosure may be implemented. That is, there is no need to store a plurality of criterion positive electrode profiles Rp and/or a plurality of criterion negative electrode profiles Rn in the storage unit 140. Accordingly, the storage capacity of the storage unit 140 does not need to be high, and there is no need to conduct numerous preliminary tests required to secure a plurality of criterion positive electrode profiles Rp and/or a plurality of criterion negative electrode profiles Rn.

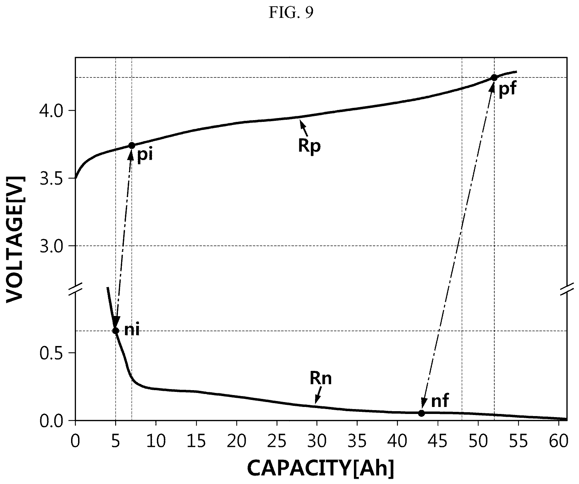

FIGS. 9 to 11 are diagrams referenced to for explaining an example of a procedure for generating a comparison full-cell profile used for comparison with the measurement full-cell profile M according to an embodiment of the present disclosure.

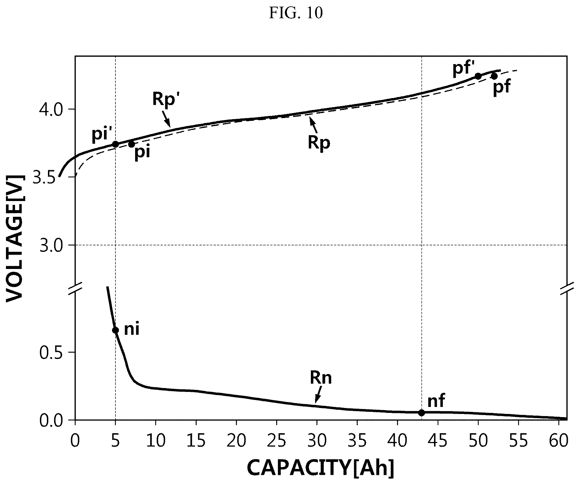

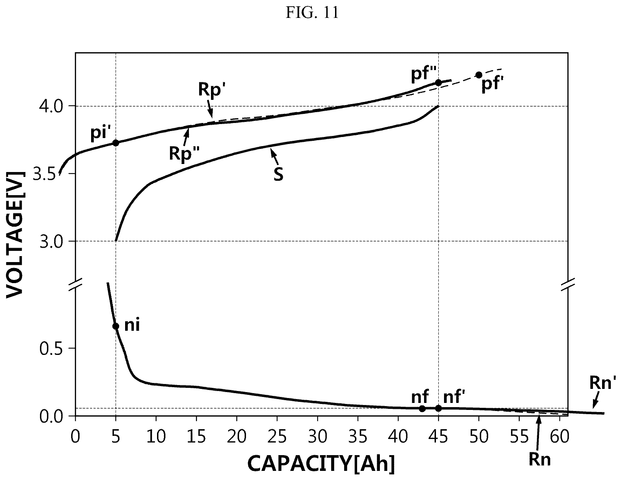

The procedure for generating a comparison full-cell profile, which will be described with reference to FIGS. 9 to 11, proceeds in the following order: a first routine that sets four points (positive electrode participation initiating point, positive electrode participation finalizing point, negative electrode participation initiating point, negative electrode participation finalizing point) to correspond to the voltage range of interest (see FIG. 9), a second routine that performs profile shifting (see FIG. 10), and a third routine that performs capacity scaling (see FIG. 11). That is, the procedure for generating a comparison full-cell profile according to an embodiment of the present disclosure includes the first to third processes.

First, referring to FIG. 9, the criterion positive electrode profile Rp and the criterion negative electrode profile Rn are the same as those shown in FIG. 7.

The profile correcting unit 120 determines a positive electrode participation initiating point pi, a positive electrode participation finalizing point pf, a negative electrode participation initiating point ni, and a negative electrode participation finalizing point nf on the criterion positive electrode profile Rp and the criterion negative electrode profile Rn.

Either the positive electrode participation initiating point pi or the negative electrode participation initiating point ni depends on the other.

As an example, the profile correcting unit 120 divides the positive electrode voltage range from the starting point of the criterion positive electrode profile Rp to the end point (or second setting voltage) into a plurality of micro voltage sections, and then set the boundary point of two adjacent micro voltage sections among the plurality of micro voltage sections as the positive electrode participation initiating point pi. Each micro voltage section may have a predetermined size (e.g., 0.01 V). Next, the profile correcting unit 120 may set a point on the criterion negative electrode profile Rn, which is smaller than the positive electrode participation initiating point pi by the first setting voltage (e.g., 3 V), as the negative electrode participation initiating point ni.

As another example, the profile correcting unit 120 may divide the negative electrode voltage range from the start point to the end point of the criterion negative electrode profile Rn into a plurality of micro voltage sections of a predetermined size, and then set the boundary point of two adjacent micro voltage sections among the plurality of micro voltage sections as the negative electrode participation initiating point ni. Next, the profile correcting unit 120 may search for a point, which is greater than the negative electrode participation initiating point ni by the first setting voltage, from the criterion positive electrode profile Rp and set the searched point as the positive electrode participation initiating point pi.

Ether the positive electrode participation finalizing point pf and the negative electrode participation finalizing point nf depends on the other.

As an example, the profile correcting unit 120 may divide the voltage range from the second setting voltage to the end point of the criterion positive electrode profile Rp into a plurality of micro voltage sections of a predetermined size, and then set the boundary point of two adjacent micro voltage sections among the plurality of micro voltage sections as the positive electrode participation finalizing point pf. Next, the profile correcting unit 120 may set a point on the criterion negative electrode profile Rn, which is smaller than the positive electrode participation finalizing point pf by a second setting voltage (e.g., 4 V), as the negative electrode participation finalizing point nf.

As another example, the profile correcting unit 120 may divide the negative electrode voltage range from the start point to the end point of the criterion negative electrode profile Rn into a plurality of micro voltage sections of a predetermined size, and then set the boundary point of two adjacent micro voltage sections among the plurality of micro voltage sections as the negative electrode participation finalizing point nf. Next, the profile correcting unit 120 may search for a point, which is greater than the negative electrode participation finalizing point nf by a second setting voltage, from the criterion positive electrode profile Rp and set the searched point as the positive electrode participation finalizing point pf.

If the determination of the positive electrode participation initiating point pi, the positive electrode participation finalizing point pf, the negative electrode participation initiating point ni, and the negative electrode participation finalizing point nf is completed, the profile correcting unit 120 shifts at least one of the criterion positive electrode profile Rp and the criterion negative electrode profile Rn to the left or right along the horizontal axis.

Referring to FIG. 10, the profile correcting unit 120 may shift the criterion positive electrode profile Rp and/or the criterion negative electrode profile Rn so that the capacity values of the positive electrode participation initiating point pi and the negative electrode participation initiating point ni match.

Alternatively, the profile correcting unit 120 may shift the criterion positive electrode profile Rp and/or the criterion negative electrode profile Rn so that the voltages of the positive electrode participation finalizing point pf and the negative electrode participation finalizing point nf match.

FIG. 10 shows the situation that the adjusted criterion positive electrode profile Rp' is generated by shifting only the criterion positive electrode profile Rp to the left, and as a result, the voltage of the positive electrode participation initiating point pi' matches the voltage of the negative electrode participation initiating point ni. The adjusted criterion positive electrode profile Rp' is the result of applying an adjustment procedure of shifting to the left by the voltage difference between the positive electrode participation initiating point pi and the negative electrode participation initiating point ni to the criterion positive electrode profile Rp. Therefore, the two points pi, pi' differ only in capacity value and have the same voltage. The two points pf, pf' differ only in capacity value and have the same voltage.

When the adjustment result profiles Rp', Rn in which at least one of the criterion positive electrode profile Rp and the criterion negative electrode profile Rn is shifted are secured, the profile correcting unit 120 scales the capacity range of at least one of the adjustment result profiles Rp', Rn.

According to the example shown in FIG. 10, the profile correcting unit 120 performs an additional adjustment procedure to shrink or expand at least one of the adjusted criterion positive electrode profile Rp' and the adjusted criterion negative electrode profile Rn along the horizontal axis.

Referring to FIG. 11, the profile correcting unit 120 may generate an adjusted criterion positive electrode profile Rp" by shrinking or expanding the adjusted criterion positive electrode profile Rp' so that the size of the capacity range between the two points pi', pf' of the adjusted criterion positive electrode profile Rp' matches the size of the capacity range of the measurement full-cell profile M. At this time, any one of the two points pi', pf' may be fixed. Accordingly, the capacity difference between the two points pi', pf" of the adjusted criterion positive electrode profile Rp" may be matched to the capacity range of the measurement full-cell profile M.

In addition, the profile correcting unit 120 may generate an adjusted criterion negative electrode profile Rn' by shrinking or expanding the criterion negative electrode profile Rn so that the size of the capacity range between two points ni, nf of the criterion negative electrode profile Rn matches the size of the capacity range of the measurement full-cell profile M. At this time, any one of the two points ni, nf may be fixed. Accordingly, the capacity difference between the two points ni, nf' of the adjusted criterion negative electrode profile Rn' may be matched to the capacity range of the measurement full-cell profile M.

In FIG. 11, the adjusted criterion positive electrode profile Rp" is the result of shrinkage of the adjusted criterion positive electrode profile Rp' shown in FIG. 10, and the adjusted criterion negative electrode profile Rn' is the result of expansion of the criterion negative electrode profile Rn shown in FIG. 10.

The positive electrode participation finalizing point pf" on the adjusted criterion positive electrode profile Rp" corresponds to the positive electrode participation finalizing point pf on the adjusted criterion positive electrode profile Rp'. The negative electrode participation finalizing point nf' on the adjusted criterion negative electrode profile Rn' corresponds to the negative electrode participation finalizing point nf on the criterion negative electrode profile Rn.

The capacity difference between the positive electrode participation initiating point pi' and the positive electrode participation finalizing point pf'' of the adjusted criterion positive electrode profile Rp'' corresponds to the size of the capacity range of the measurement full-cell profile M. Likewise, the capacity difference between the negative electrode participation initiating point ni and the negative electrode participation finalizing point nf' of the adjusted criterion negative electrode profile Rn' corresponds to the size of the capacity range of the measurement full-cell profile M.

In addition, the capacity range by two points pi', pf'' of the adjusted criterion positive electrode profile Rp'' matches the capacity range by two points ni, nf' of the adjusted criterion negative electrode profile Rn'. The profile correcting unit 120 may generate the comparison full-cell profile S by subtracting the profile between two points ni, nf' of the adjusted criterion negative electrode profile Rn' from the profile between two points pi', pf'' of the adjusted criterion positive electrode profile Rp''.

The profile correcting unit 120 may calculate the error (profile error) between the comparison full-cell profile S and the measurement full-cell profile M. When the error between the comparison full-cell profile S and the measurement full-cell profile M is minimized, the adjusted criterion positive electrode profile Rp'' corresponding to the comparison full-cell profile S may be determined as the adjusted positive electrode profile, and the adjusted criterion negative electrode profile Rn' may be determined as the adjusted negative electrode profile.

The profile correcting unit 120 may map at least two of the adjusted criterion positive electrode profile Rp'', the adjusted criterion negative electrode profile Rn', the positive electrode participation initiating point pi', the positive electrode participation finalizing point pf'', the negative electrode participation initiating point ni, the negative electrode participation finalizing point nf', the first scale factor, the second scale factor, the comparison full-cell profile S, and the profile error to each other and record in the storage unit 140. The first scale factor may represent the rate of the capacity difference between two points pi', pf'' relative to the capacity difference between two points pi0, pf0. The second scale factor may represent the rate of the capacity difference between two points ni, nf' relative to the capacity difference between two points ni0, nf0.

Here, the profile correcting unit 120 may calculate the positive electrode change rate (ps) of the adjusted criterion positive electrode profile Rp'' for the criterion positive electrode profile Rp. Also, the profile correcting unit 120 may calculate the negative electrode change rate (ns) of the adjusted criterion positive electrode profile Rn' for the criterion negative electrode profile Rn. For example, the profile correcting unit 120 may determine the first scale factor as the positive electrode change rate (ps) and determine the second scale factor as the negative electrode change rate (ns).

Meanwhile, as described above, when the positive electrode voltage range of the criterion positive electrode profile Rp is divided into a plurality of micro voltage sections, the boundary point of two adjacent micro voltage sections among the plurality of micro voltage sections may be set as the positive electrode participation initiating point pi.

For example, if the positive electrode voltage range of the criterion positive electrode profile Rp is divided into one hundred small voltage ranges, there may be one hundred boundary points that may be set as the positive electrode participation initiating point pi. In addition, if the voltage range equal to or greater than the second setting voltage in the criterion positive electrode profile Rp is divided into 40 small voltage ranges, there may be 40 boundary points that may be set as the positive electrode participation finalizing point pf. In this case, up to 4000 different comparison full-cell profiles may be generated.

Of course, it will be easy to understand by those skilled in the art that as the size of the micro voltage section decreases, the number of comparison full-cell profiles that may be maximally generated increases, and conversely, as the size of the micro voltage section increases, the number of comparison full-cell profiles that may be maximally generated decreases.

The profile correcting unit 120 may identify the minimum value among the profile errors of the plurality of comparison full-cell profile generated as described above, and then obtain information mapped to the minimum profile error (e.g., at least one of the positive electrode participation initiating point pi, the positive electrode participation finalizing point pf, the negative electrode participation initiating point ni, the negative electrode participation finalizing point nf, the positive electrode change rate (ps), and the negative electrode change rate (ns)) from the storage unit 140.

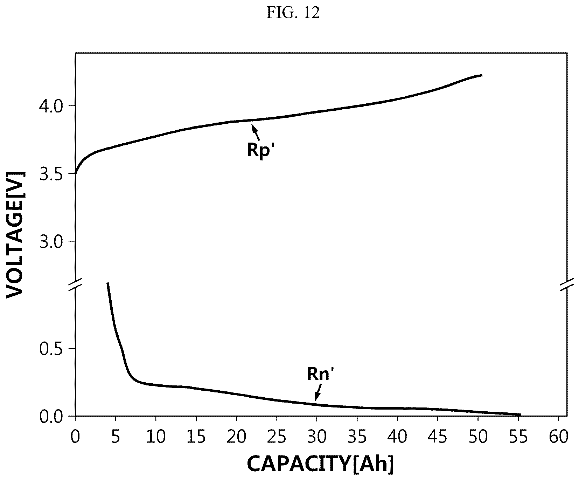

FIGS. 12 to 14 are diagrams referenced to for explaining another example of a procedure for generating a comparison full-cell profile used for comparison with the measurement full-cell profile M according to an embodiment of the present disclosure. For reference, the embodiments shown in FIGS. 12 to 14 are independent from the embodiments shown in FIGS. 9 to 11. Accordingly, terms or symbols commonly used in describing the embodiments shown in FIGS. 9 to 11 and the embodiments shown in FIGS. 12 to 14 should be understood as being limited to each embodiment.

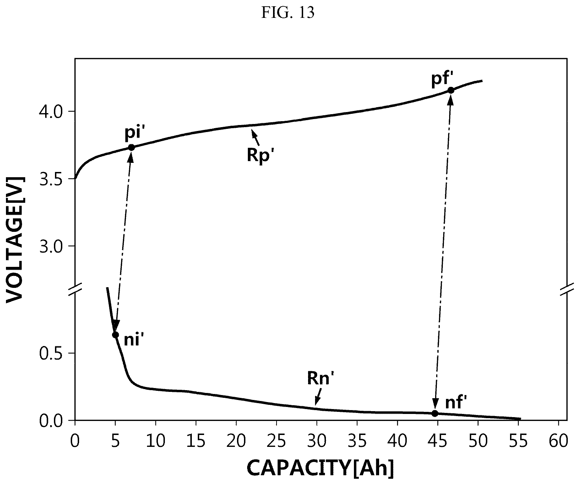

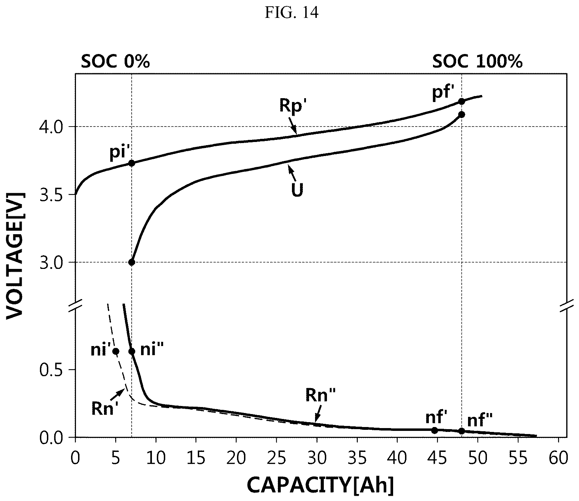

The generation procedure of the comparison full-cell profile to be explained with reference to FIGS. 12 to 14 proceeds in the following order: a fourth routine for performing capacity scaling (see FIG. 12), a fifth routine of setting four points (the positive electrode participation initiating point, the positive electrode participation finalizing point, the negative electrode participation initiating point and the negative electrode participation finalizing point (see FIG. 13), and a sixth routine of performing profile shift (see FIG. 14). That is, the generation procedure of the comparison full-cell profile according to another embodiment of the present disclosure includes the fourth to sixth processes.

Referring to FIG. 12, the criterion positive electrode profile Rp and the criterion negative electrode profile Rn are the same as those shown in FIG. 7.

The profile correcting unit 120 generates an adjusted criterion positive electrode profile Rp' and an adjusted criterion negative electrode profile Rn' by applying the first scale factor and the second scale factor selected from the scaling value range to the criterion positive electrode profile Rp and the criterion negative electrode profile Rn, respectively.

The scaling value range may be predetermined or may vary depending on the rate of the size of the capacity range of the measurement full-cell profile M relative to the size of the capacity range of the criterion full-cell profile R. As an example, assuming that the first scale factor and the second scale factor may be selected among the values spaced by 0.1% (i.e., 90%, 90.1%, 90.2%, ..., 98.9%, 99%) in the scaling numerical range (e.g., 90 to 99%), 91 values may be selected as the first scale factor and the second scale factor, respectively. In this case, up to 8,281 adjusted profile pairs may be generated to 91 × 91 = 8,281 adjustment levels (combination of first scale factor and second scale factor). The adjusted profile pair refers to a combination of the adjusted criterion positive electrode profile and the adjusted criterion negative electrode profile.

FIG. 12 shows an example in which the adjusted criterion positive electrode profile Rp' and the adjusted criterion negative electrode profile Rn' are the results of applying a first scale factor and a second scale factor less than 100% to the criterion positive electrode profile Rp and the criterion negative electrode profile Rn, respectively.

Since the first scale factor and the second scale factor are less than 100%, the adjusted criterion positive electrode profile Rp' is the shrinkage of the criterion positive electrode profile Rp along the horizontal axis, and the adjusted criterion negative electrode profile Rn' is also the shrinkage of the criterion negative electrode profile Rn along the horizontal axis. To facilitate understanding, the example is illustrated in the form where the starting point of each of the positive electrode profile Rp and the criterion negative electrode profile Rn is fixed and the remaining portions are reduced to the left along the horizontal axis.

Referring to FIG. 13, the profile correcting unit 120 determines the positive electrode participation initiating point pi', the positive electrode participation finalizing point pf', the negative electrode participation initiating point ni' and the negative electrode participation finalizing point nf' on the adjusted criterion positive electrode profile Rp' and the adjusted criterion negative electrode profile Rn'.

Either the positive electrode participation initiating point pi' or the negative electrode participation initiating point ni' may depend on the other. Additionally, either the positive electrode participation finalizing point pf' or the negative electrode participation finalizing point nf' may depend on the other. Additionally, either the positive electrode participation initiating point pi' or the positive electrode participation finalizing point pf' may be set based on the other.

That is, if any one of the positive electrode participation initiating point pi', the positive electrode participation finalizing point pf', the negative electrode participation initiating point ni', and the negative electrode participation finalizing point nf' is set, the remaining three points may be set automatically by the first setting voltage, the second setting voltage and/or the size of the capacity range of the measurement full-cell profile M (e.g., charging capacity of SOC 0% to 100%).

As an example, the profile correcting unit 120 may divide the positive electrode voltage range from the start point of the adjusted criterion positive electrode profile Rp' to the end point (or second setting voltage) into a plurality of micro voltage section, and then set the boundary point of two adjacent micro voltage sections among the plurality of micro voltage sections as the positive electrode participation initiating point pi'. Next, the profile correcting unit 120 may set the point on the adjusted criterion negative electrode profile Rn, which is smaller than the positive electrode participation initiating point pi' by the first setting voltage (e.g., 3 V), as the negative electrode participation initiating point ni'.

As another example, the profile correcting unit 120 may divide the negative electrode voltage range from the start point to the end point of the adjusted criterion negative electrode profile Rn' into a plurality of micro voltage sections of a predetermined size, and then set the boundary point of two adjacent voltage sections among the plurality of micro voltage sections as the negative electrode participation initiating point ni'. Next, the profile correcting unit 120 may search for a point, which is greater than the negative electrode participation initiating point ni' by the first setting voltage, from the criterion positive electrode profile Rp and set the searched point as the positive electrode participation initiating point pi'.

As another example, the profile correcting unit 120 may divide the voltage range from the second setting voltage to the end point of the adjusted criterion positive electrode profile Rp' into a plurality of micro voltage sections of a predetermined size, and then set the boundary point of the two micro voltage sections among the plurality of micro voltage sections as the positive electrode participation finalizing point pf'. Next, the profile correcting unit 120 may search for a point, which is smaller than the positive electrode participation finalizing point pf' by the second setting voltage (e.g., 4 V), in the adjusted criterion negative electrode profile Rn', and set the searched point as the negative electrode participation finalizing point 'nf'.

As another example, the profile correcting unit 120 may divide the negative electrode voltage range from the start point to the end point of the adjusted criterion negative electrode profile Rn' into a plurality of micro voltage sections of a predetermined size, and then set the boundary point of two adjacent micro voltage sections among the plurality of micro voltage sections as the negative electrode participation finalizing point nf'. Next, the profile correcting unit 120 may search for a point, which is greater than the negative electrode participation finalizing point nf' by the second setting voltage, from the adjusted criterion positive electrode profile Rp' and set the searched point as the positive electrode participation finalizing point pf'.

If any one of the positive electrode participation initiating point pi', the positive electrode participation finalizing point pf', the negative electrode participation initiating point ni', and the negative electrode participation finalizing point nf' is determined, the profile correcting unit 120 may additionally determine the remaining points based on the determined point.

As an example, if the positive electrode participation initiating point pi' is determined first, the profile correcting unit 120 may set the point on the adjusted criterion positive electrode profile Rp', which has a capacity value that is larger than the capacity value of the positive electrode participation initiating point pi' by the size of the capacity range of the measurement full-cell profile M, as the positive electrode participation finalizing point pf'. Additionally, the profile correcting unit 120 may search for a point, which is lower than the positive electrode participation initiating point pi' by the first setting voltage, from the adjusted criterion negative electrode profile Rn' and set the searched point as the negative electrode participation initiating point ni'. In addition, the profile correcting unit 120 may set a point on the adjusted criterion negative electrode profile Rn', which has a capacity value larger than the capacity value of the negative electrode participation initiating point ni' by the size of the capacity range of the measurement full-cell profile M, as the negative electrode participation finalizing point nf'.

As another example, if the positive electrode participation finalizing point pf' is determined first, the profile correcting unit 120 may set a point on the adjusted criterion positive electrode profile Rp', which has a capacity value smaller than the capacity value of the positive electrode participation finalizing point pf' by the size of the capacity range of the measurement full-cell profile M, as the positive electrode participation initiating point pi'. Additionally, the profile correcting unit 120 may search for a point, which is lower than the positive electrode participation finalizing point pf' by the second setting voltage, from the adjusted criterion negative electrode profile Rn' and set the searched point as the negative electrode participation finalizing point nf'. In addition, the profile correcting unit 120 may set a point on the adjusted criterion negative electrode profile Rn', which has a capacity value smaller than the capacity value of the negative electrode participation finalizing point nf' by the size of the capacity range of the measurement full-cell profile M, as the negative electrode participation initiating point ni'.

As still another example, if the negative electrode participation initiating point ni' is determined, the profile correcting unit 120 may set a point on the criterion negative electrode profile Rn', which has a capacity value larger than the capacity value of the negative electrode participation initiating point ni' by the size of the capacity range of the measurement full-cell profile M, set as the negative electrode participation finalizing point nf'. Additionally, the profile correcting unit 120 may search for a point, which is higher than the negative electrode participation initiating point ni' by the first setting voltage, from the adjusted criterion positive electrode profile Rp' and set the searched point as the positive electrode participation initiating point pi'. In addition, the profile correcting unit 120 may set a point on the adjusted criterion positive electrode profile Rp', which has a capacity value greater than the capacity value of the positive electrode participation initiating point pi' by the size of the capacity range of the measurement full-cell profile M, as the positive electrode participation finalizing point pf'.

As still another example, if the negative electrode participation finalizing point nf' is determined, the profile correcting unit 120 may set a point on the criterion negative electrode profile Rn', which has a capacity value smaller than the capacity value of the negative electrode participation finalizing point nf' by the size of the capacity range of the measurement full-cell profile M, as the negative electrode participation initiating point ni'. Additionally, the profile correcting unit 120 may search for a point, which is higher than the negative electrode participation finalizing point nf' by the second setting voltage, from the adjusted criterion positive electrode profile Rp' and set the searched point as the positive electrode participation finalizing point pf'. In addition, the profile correcting unit 120 may set a point on the adjusted criterion positive electrode profile Rp', which has a capacity value smaller than the capacity value of the positive electrode participation finalizing point pf' by the size of the capacity range of the measurement full-cell profile M, as the positive electrode participation initiating point pi'.

If the determination of the positive electrode participation initiating point pi', the positive electrode participation finalizing point pf', the negative electrode participation initiating point ni' and the negative electrode participation finalizing point nf' is completed based on the pair of first scale factor and second scale factor, the profile correcting unit 120 may shift at least one of the adjusted criterion positive electrode profile Rp' and the adjusted criterion negative electrode profile Rn' along the horizontal axis so that the capacity values of the positive electrode participation initiating point pi' and the negative electrode participation initiating point ni' match or the capacity values of the positive electrode participation finalizing point pf' and the negative electrode participation finalizing point nf' match.

The adjusted criterion negative electrode profile Rn" shown in FIG. 14 is obtained by shifting only the adjusted criterion negative electrode profile Rn' shown in FIG. 13 to the right. Accordingly, the capacity values of the positive electrode participation initiating point pi' and the negative electrode participation initiating point ni" do not match each other. In this regard, since the capacity difference between the positive electrode participation initiating point pi' and the positive electrode participation finalizing point pf' is the same as the capacity difference between the negative electrode participation initiating point ni' and the negative electrode participation finalizing point nf', if the capacity values of the positive electrode participation initiating point pi' and the negative electrode participation initiating point ni" match each other, the capacity values of the positive electrode participation finalizing point pf' and the negative electrode participation finalizing point nf" also match each other.

Referring to FIG. 14, the profile correcting unit 120 may generate the comparison full-cell profile U by subtracting a partial profile between two points pi', pf' of the adjusted criterion positive electrode profile Rp' from the partial profile between into two points ni", nf' of the adjusted criterion negative electrode profile Rn".

The profile correcting unit 120 may calculate the error (profile error) between the comparison full-cell profile U and the measurement full-cell profile M. When the error between the comparison full-cell profile U and the measurement full-cell profile M is minimized, the adjusted criterion positive electrode profile Rp' corresponding to the comparison full-cell profile U may be determined as the adjusted positive electrode profile, and the adjusted criterion negative electrode profile Rn" may be determined as the adjusted negative electrode profile.

The profile correcting unit 120 may map at least two of the adjusted criterion positive electrode profile Rp', the adjusted criterion negative electrode profile Rn", the positive electrode participation initiating point pi', the positive electrode participation finalizing point pf', the negative electrode participation initiating point ni", the negative electrode participation finalizing point nf", the positive electrode change rate ps, the negative electrode change rate ns, the comparison full-cell profile U, and the profile error with each other and record in the storage unit 140.

Here, the profile correcting unit 120 may calculate the positive electrode change rate ps of the adjusted criterion positive electrode profile Rp' for the criterion positive electrode profile Rp. Also, the profile correcting unit 120 may calculate the negative electrode change rate ns of the adjusted criterion negative electrode profile Rn" for the criterion negative electrode profile Rn. For example, the profile correcting unit 120 may determine the first scale factor as the positive electrode change rate ps and determine the second scale factor as the negative electrode change rate ns.

As described above, the profile correcting unit 120 may generate a comparison full-cell profile corresponding to each pair of first scale factor and second scale factor selected from the scaling value range. Since the pair of first scale factor and second scale factor is plural, it is obvious that the comparison full-cell profile will also be generated in plural. The profile correcting unit 120 may identify the minimum value among the profile errors of the plurality of comparison full-cell profiles and then obtain information mapped to the minimum profile error from the storage unit 140.

The apparatus 100 for diagnosing a battery according to the present disclosure may be connected to a display device (not shown) and output information on a battery diagnosed as being in an abnormal state. Because of this, the information about the battery diagnosed as being in an abnormal state may be displayed on the display device.

The apparatus 100 for diagnosing a battery according to the present disclosure may be connected to an alarm device (not shown) and output information on a battery diagnosed as being in an abnormal state to operate the alarm device.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the profile correcting unit 120, the control unit 130 and the storage unit 140 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

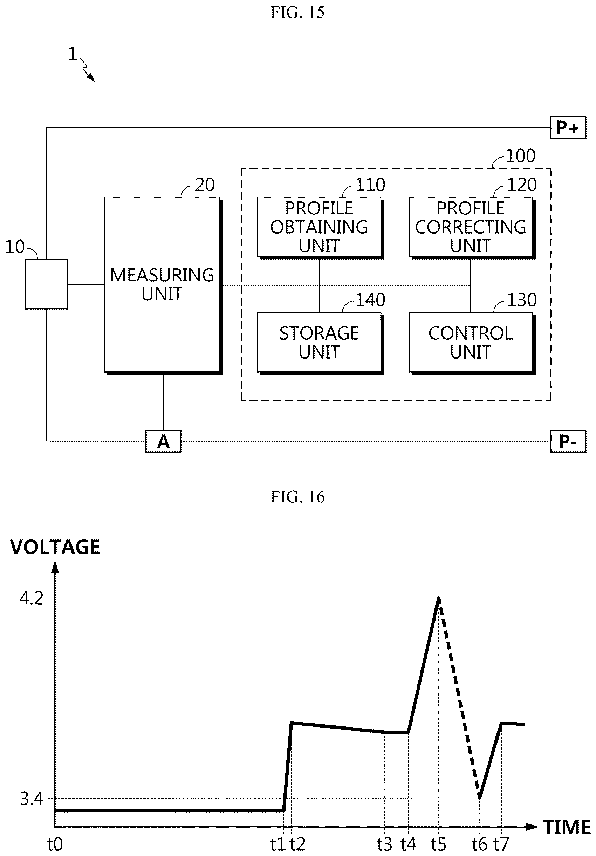

FIG. 15 is a diagram showing an exemplary configuration of a battery pack 1 according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to the positive electrode terminal and the negative electrode terminal of the battery 10. Additionally, the measuring unit 20 may measure the voltage of the battery 10 by measuring the positive electrode potential and the negative electrode potential of the battery 10 and calculating the difference between the positive electrode potential and the negative electrode potential.

In addition, the measuring unit 20 may be connected to a current measurement unit A. For example, the current measurement unit A may be an ammeter or shunt resistor that may measure the charging current and discharging current of the battery 10. The measuring unit 20 may calculate the charging amount by measuring the charging current of the battery 10 using the current measurement unit A. Additionally, the measuring unit 20 may calculate the discharge amount by measuring the discharge current of the battery 10 through the current measurement unit A.

For example, the information about the voltage and capacity of the battery 10 measured by the measuring unit 20 may be transmitted to the profile obtaining unit 110. Additionally, the profile obtaining unit 110 may directly generate a battery profile BP based on the received information about the voltage and capacity.

As another example, the information about the voltage and capacity of the battery 10 measured by the measuring unit 20 may be stored in the storage unit 140. When the charging or discharging of the battery 10 is completed, the profile obtaining unit 110 may access the storage unit 140 to obtain the battery profile BP.

As still another example, the measuring unit 20 may directly generate a battery profile BP based on the measured information about the voltage and capacity of the battery 10. In this case, the generated battery profile BP may be transmitted to the profile obtaining unit 110 and also be stored in the storage unit 140.

A charge/discharge device or load may be connected to the positive electrode terminal P+ and the negative electrode terminal P- of the battery pack 1.

FIG. 16 is a diagram for explaining a process of manufacturing a battery cell by a battery manufacturing system according to still another embodiment of the present disclosure. Specifically, FIG. 16 is a diagram schematically showing the process of activating a manufactured battery cell over time.

Referring to FIG. 16, the aging process proceeds in the first step from the t0 time point to the t1 time point. Here, the aging process refers to a process of leaving the battery cell under specific conditions. In the first step, the electrolyte may be impregnated.

Primary charging proceeds in the second step from the t1 time point to the t2 time point. In the second step, a film layer (SEI, solid electrolyte interphase) may be formed on the negative electrode.

A high temperature aging process proceeds in the third step from the t2 time point to the t3 time point. For example, in the third step, aging occurs under high temperature conditions of 60°C, and the film layer formed in the second step may be stabilized.

The degassing process proceeds in the fourth step from the t3 time point to the t4 time point. In the fourth step, the gas contained inside the battery cell may be removed.

The process of charging the battery cell proceeds in the fifth step from the t4 time point to the t5 time point. The battery cell discharge process proceeds in the sixth step from the t5 time point to the t6 time point. Here, the fifth step and the sixth step may be combined and referred to as the battery cell capacity inspection process. Generally, the sixth step is a step of detecting a defect in the battery cell while discharging a fully charged battery cell, and is a process step of discharging the battery cell at a discharge C-rate determined in consideration of the inspection time and inspection accuracy. For example, in the sixth step, the battery cell is discharged at 0.3 C, and the battery profile BP for capacity and voltage may be obtained during the discharge process. Also, based on the obtained battery profile BP, it may be detected whether the battery cell is defective.

In the seventh step from the t6 time point to the t7 time point, the shipping and charging process to ship the battery cell is carried out.

The apparatus 100 for diagnosing a battery according to an embodiment of the present disclosure may obtain a battery profile BP generated in the discharge process of the sixth step. Also, by removing the overpotential included in the battery profile BP using the overpotential profile OP corresponding to the target C-rate set in the discharge process, the corrected profile CP for the plurality of battery cells may be obtained. Also, the apparatus 100 for diagnosing a battery may diagnose the state of the plurality of battery cells based on the plurality of corrected profiles CP. In other words, the apparatus 100 for diagnosing a battery may be used in the battery cell activation process step to quickly and accurately diagnose defects in the manufactured battery cell. In particular, the apparatus 100 for diagnosing a battery has an advantage of detecting defective battery cells more accurately because it diagnoses the state of the battery cell after removing the overpotential that may be included in the battery profile BP obtained in the capacity inspection process.

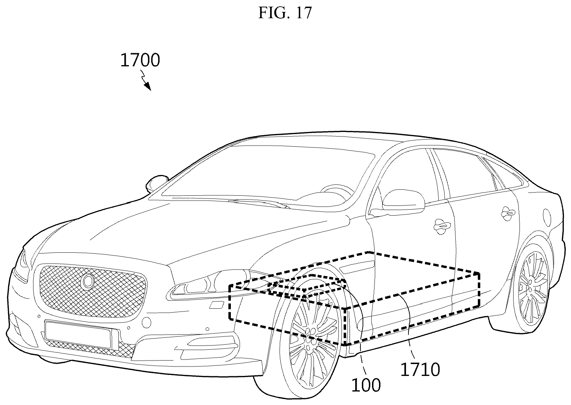

FIG. 17 is a diagram showing an exemplary configuration of a vehicle according to still another embodiment of the present disclosure.

Referring to FIG. 17, the battery pack 1710 according to an embodiment of the present disclosure may be included in a vehicle 1700 such as an electric vehicle (EV) or a hybrid vehicle (HV). In addition, the battery pack 1710 may drive the vehicle 1700 by supplying power to a motor through an inverter included in the vehicle 1700. Here, the battery pack 1710 may include the apparatus 100 for diagnosing a battery. That is, the vehicle 1700 may include the apparatus 100 for diagnosing a battery. In this case, the apparatus 100 for diagnosing a battery may be an on-board diagnostic device included in the vehicle 1700.

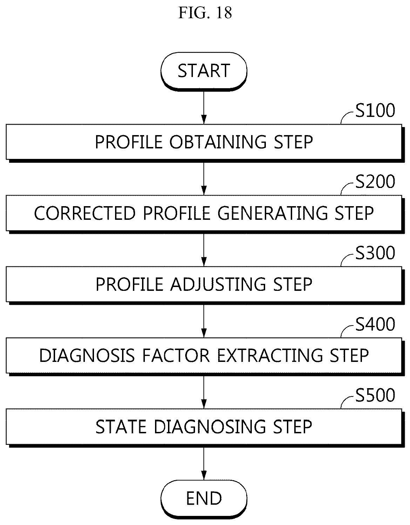

FIG. 18 is a diagram schematically showing a method for diagnosing a battery according to still another embodiment of the present disclosure.

The method for diagnosing a battery may include a profile obtaining step (S100), a corrected profile generating step (S200), a profile adjusting step (S300), a diagnosis factor extracting step (S400), and a state diagnosing step (S500).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining each of a plurality of battery profiles BP indicating the correspondence relationship between voltage and capacity of each of the plurality of batteries, and may be performed by the profile obtaining unit 110.

For example, the profile obtaining unit 110 may directly receive the battery profile BP from the outside. That is, the profile obtaining unit 110 may obtain the battery profile BP by receiving the battery profile BP by being connected to the outside wired and/or wirelessly.

As another example, the profile obtaining unit 110 may receive battery information about the voltage (V) and capacity (Q) of the battery. Additionally, the profile obtaining unit 110 may generate a battery profile BP based on the received battery information. That is, the profile obtaining unit 110 may obtain the battery profile BP by directly generating the battery profile BP based on the battery information.

The corrected profile generating step (S200) is a step for generating a plurality of corrected profiles CP by correcting the plurality of battery profiles BP based on a preset overpotential profile OP, and may be performed by the profile correcting unit 120.

Specifically, the profile correcting unit 120 may remove the overpotential profile OP from the battery profile BP. For example, the profile correcting unit 120 may calculate the difference between the voltage of the battery profile BP and the overpotential of the overpotential profile OP for the same capacity. The profile correcting unit 120 may generate a corrected profile CP by calculating the difference between the voltage of the battery profile BP and the overpotential of the overpotential profile OP at the total capacity.

The profile adjusting step (S300) is a step of generating an adjusted positive electrode profile and an adjusted negative electrode profile corresponding to each battery by adjusting a preset criterion positive electrode profile and a preset criterion negative electrode profile to correspond to each of the plurality of corrected profiles CP, and may be performed by the profile correcting unit 120.

For example, the profile correcting unit 120 may generate a plurality of comparison full-cell profiles by shifting the criterion positive electrode profile and the criterion negative electrode profile or scaling the capacity thereof, and specify a comparison full-cell profile having a minimum error with the corrected profile CP among the plurality of comparison full-cell profiles. Also, an adjusted positive electrode profile and an adjusted negative electrode profile corresponding to the specified comparison full-cell profile may be determined.

The diagnosis factor extracting step (S400) is a step of extracting a diagnosis factor for a positive electrode change rate of each battery from the criterion positive electrode profile and the adjusted positive electrode profile, and may be performed by the control unit 130.

The state diagnosing step (S500) is a step of diagnosing the state of the plurality of batteries based on the extracted plurality of diagnosis factors, and may be performed by the control unit 130.

For example, the control unit 130 may be configured to select a diagnosis factor that is outside the threshold range TH among the plurality of diagnosis factors in consideration of the distribution of the plurality of diagnosis factors, and diagnose the state of the battery corresponding to the selected diagnosis factor as an abnormal state. Conversely, the control unit 130 may be configured to select a diagnosis factor included in the threshold range TH among the plurality of diagnosis factors and diagnose the state of the battery corresponding to the selected diagnosis factor as a normal state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Explanation of reference signs)

    1: battery pack
    10: battery

20: measuring unit
100: apparatus for diagnosing a battery
110: profile obtaining unit
120: profile correcting unit
130: control unit
140: storage unit
1700: vehicle
1710: battery pack

**Claims**

1. An apparatus for diagnosing a battery, comprising:

   a profile obtaining unit configured to obtain each of a plurality of battery profiles representing a correspondence relationship between voltage and capacity of each of a plurality of batteries; a profile correcting unit configured to generate a plurality of corrected profiles by correcting the plurality of battery profiles based on a preset overpotential profile, and generate an adjusted positive electrode profile and an adjusted negative electrode profile corresponding to each battery by adjusting a preset criterion positive electrode profile and a criterion negative electrode profile to correspond to each of the plurality of corrected profiles; and a control unit configured to extract a diagnosis factor regarding a positive electrode change rate for each battery from the criterion positive electrode profile and the adjusted positive electrode profile, and diagnose a state of the plurality of batteries based on the extracted plurality of diagnosis factors.

2. The apparatus for diagnosing a battery according to claim 1,
   wherein the overpotential profile is a profile that represents a voltage difference for each capacity between a battery profile of a criterion battery for a criterion C-rate and a battery profile of the criterion battery for a target C-rate set for the plurality of batteries.

3. The apparatus for diagnosing a battery according to claim 2,
   wherein the profile correcting unit is configured to generate the plurality of corrected profiles by calculating a voltage difference for each capacity between each of the plurality of battery profiles and the overpotential profile.

4. The apparatus for diagnosing a battery according to claim 2,
   wherein the overpotential profile is configured to be stored in advance for each of a plurality of C-rates, and
   wherein the profile correcting unit is configured to select an overpotential profile corresponding to the target C-rate among a plurality of overpotential profiles stored in advance, and generate the plurality of corrected profiles using the selected overpotential profile.

5. The apparatus for diagnosing a battery according to claim 1,
   wherein the control unit is configured to select a diagnosis factor out of a threshold range among the plurality of diagnosis factors by considering a distribution of the plurality of diagnosis factors, and diagnose the state of a battery corresponding to the selected diagnosis factor as an abnormal state.

6. The apparatus for diagnosing a battery according to claim 1,
   wherein the profile correcting unit is configured to generate a comparison full-cell profile based on the criterion positive electrode profile and the criterion negative electrode profile, and generate the adjusted positive electrode profile and the adjusted negative electrode profile by adjusting the criterion positive electrode profile and the criterion negative electrode profile until the generated comparison full-cell profile corresponds to the corrected profile.

7. A battery pack, comprising the apparatus for diagnosing a battery according to any one of claims 1 to 6.

8. A battery manufacturing system, comprising the apparatus for diagnosing a battery according to any one of claims 1 to 6.

9. A vehicle, comprising the apparatus for diagnosing a battery according to any one of claims 1 to 6.

10. A method for diagnosing a battery, comprising:

    a profile obtaining step of obtaining each of a plurality of battery profiles representing a correspondence relationship between voltage and capacity of each of a plurality of batteries; a corrected profile generating step of generating a plurality of corrected profiles by correcting the plurality of battery profiles based on a preset overpotential profile; a profile adjusting step of generating an adjusted positive electrode profile and an adjusted negative electrode profile corresponding to each battery by adjusting a preset criterion positive electrode profile and a criterion negative electrode profile to correspond to each of the plurality of corrected profiles; a diagnosis factor extracting step of extracting a diagnosis factor regarding a positive electrode change rate for each battery from the adjusted positive electrode profile; and
a state diagnosing step of diagnosing a state of the plurality of batteries based on the extracted plurality of diagnosis factors.

FIG. 1

APPARATUS FOR DIAGNOSING BATTERY ~100

PROFILE OBTAINING UNIT ~110

PROFILE CORRECTING UNIT ~120

CONTROL UNIT ~130

STORAGE UNIT ~140

FIG. 2

FIG. 3

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

FIG. 18

```
                    ╭─────────╮
                    │  START  │
                    ╰────┬────╯
                         │              ⟋S100
            ┌────────────▼──────────────────┐
            │    PROFILE OBTAINING STEP      │
            └────────────┬──────────────────┘
                         │              ⟋S200
            ┌────────────▼──────────────────┐
            │ CORRECTED PROFILE GENERATING STEP │
            └────────────┬──────────────────┘
                         │              ⟋S300
            ┌────────────▼──────────────────┐
            │     PROFILE ADJUSTING STEP     │
            └────────────┬──────────────────┘
                         │              ⟋S400
            ┌────────────▼──────────────────┐
            │ DIAGNOSIS FACTOR EXTRACTING STEP │
            └────────────┬──────────────────┘
                         │              ⟋S500
            ┌────────────▼──────────────────┐
            │    STATE DIAGNOSING STEP       │
            └────────────┬──────────────────┘
                         │
                    ╭────▼────╮
                    │   END   │
                    ╰─────────╯
```

# EP 4 715 407 A1

<table>
<tr><td colspan="2">INTERNATIONAL SEARCH REPORT</td><td>International application No.<br><br>**PCT/KR2024/012784**</td></tr>
</table>

**A. CLASSIFICATION OF SUBJECT MATTER**

**G01R 31/374**(2019.01)i; **G01R 31/396**(2019.01)i; **G01R 31/382**(2019.01)i; **G01R 31/385**(2019.01)i; **G01R 31/392**(2019.01)i; **G01R 19/165**(2006.01)i; **G01R 19/10**(2006.01)i; **B60L 58/10**(2019.01)i

According to International Patent Classification (IPC) or to both national classification and IPC

**B. FIELDS SEARCHED**

Minimum documentation searched (classification system followed by classification symbols)

G01R 31/374(2019.01); G01R 31/36(2006.01); G01R 31/367(2019.01); H01M 10/48(2006.01); H02J 7/00(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 용량(capacity), 전압(voltage), 프로파일(profile), 보정(compensate), 양극(anode), 음극(cathode)

**C. DOCUMENTS CONSIDERED TO BE RELEVANT**

| Category* | Citation of document, with indication, where appropriate, of the relevant passages | Relevant to claim No. |
|---|---|---|
| A | KR 10-2022-0093840 A (LG ENERGY SOLUTION, LTD.) 05 July 2022 (2022-07-05)<br>See claims 1-10. | 1-10 |
| A | KR 10-2023-0036707 A (SAMSUNG ELECTRONICS CO., LTD.) 15 March 2023 (2023-03-15)<br>See claims 1-20. | 1-10 |
| A | KR 10-2018-0103412 A (LG CHEM, LTD.) 19 September 2018 (2018-09-19)<br>See claims 1-10. | 1-10 |
| A | KR 10-2022-0021730 A (LG ENERGY SOLUTION, LTD.) 22 February 2022 (2022-02-22)<br>See claims 1-10. | 1-10 |
| A | KR 10-2022-0021276 A (LG ENERGY SOLUTION, LTD.) 22 February 2022 (2022-02-22)<br>See claims 1-10. | 1-10 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **12 December 2024** | **12 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

| INTERNATIONAL SEARCH REPORT Information on patent family members | | International application No. PCT/KR2024/012784 |
|---|---|---|

| Patent document cited in search report | | | Publication date (day/month/year) | Patent family member(s) | | | Publication date (day/month/year) |
|---|---|---|---|---|---|---|---|
| KR | 10-2022-0093840 | A | 05 July 2022 | CN | 115380221 | A | 22 November 2022 |
| | | | | EP | 4119962 | A1 | 18 January 2023 |
| | | | | JP | 2023-515838 | A | 14 April 2023 |
| | | | | JP | 7395809 | B2 | 12 December 2023 |
| | | | | US | 12066496 | B2 | 20 August 2024 |
| | | | | US | 2023-0236262 | A1 | 27 July 2023 |
| | | | | US | 2024-0377472 | A1 | 14 November 2024 |
| | | | | WO | 2022-145776 | A1 | 07 July 2022 |
| KR | 10-2023-0036707 | A | 15 March 2023 | CN | 115774212 | A | 10 March 2023 |
| | | | | EP | 4148443 | A1 | 15 March 2023 |
| | | | | EP | 4148443 | B1 | 20 March 2024 |
| | | | | US | 2023-0073869 | A1 | 09 March 2023 |
| KR | 10-2018-0103412 | A | 19 September 2018 | CN | 109923753 | A | 21 June 2019 |
| | | | | CN | 109923753 | B | 06 December 2022 |
| | | | | EP | 3518381 | A1 | 31 July 2019 |
| | | | | EP | 3518381 | B1 | 02 June 2021 |
| | | | | KR | 10-2254353 | B1 | 21 May 2021 |
| | | | | US | 11056901 | B2 | 06 July 2021 |
| | | | | US | 2019-0237975 | A1 | 01 August 2019 |
| | | | | WO | 2018-164523 | A1 | 13 September 2018 |
| KR | 10-2022-0021730 | A | 22 February 2022 | CN | 115413382 | A | 29 November 2022 |
| | | | | EP | 4131571 | A1 | 08 February 2023 |
| | | | | JP | 2023-517738 | A | 26 April 2023 |
| | | | | JP | 7372007 | B2 | 31 October 2023 |
| | | | | KR | 10-2596153 | B1 | 30 October 2023 |
| | | | | US | 11990590 | B2 | 21 May 2024 |
| | | | | US | 2023-0207910 | A1 | 29 June 2023 |
| | | | | US | 2024-0274902 | A1 | 15 August 2024 |
| | | | | WO | 2022-035032 | A1 | 17 February 2022 |
| KR | 10-2022-0021276 | A | 22 February 2022 | CN | 115461636 | A | 09 December 2022 |
| | | | | EP | 4148441 | A1 | 15 March 2023 |
| | | | | JP | 2023-523803 | A | 07 June 2023 |
| | | | | JP | 7351024 | B2 | 26 September 2023 |
| | | | | US | 2023-0176130 | A1 | 08 June 2023 |
| | | | | WO | 2022-035130 | A1 | 17 February 2022 |

Form PCT/ISA/210 (patent family annex) (July 2022)

## REFERENCES CITED IN THE DESCRIPTION

**Patent documents cited in the description**

- KR 1020230115861